# EUROPÄISCHE PATENTANMELDUNG

(11) **EP 1 679 744 A1**
(43) Veröffentlichungstag der Anmeldung: **12.07.2006**
(21) Anmeldenummer: 05028422.3
(22) Anmeldetag: 23.12.2005
(51) Int. Cl.: H01L 23/473

(54) **Kühlvorrichtung, insbesondere für ein elektrisches Leistungshalbleiterbauelement**

(30) Priorität: 11.01.2005 DE 102005001360
(71) Anmelder: ALSTOM, 92300 Levallois-Perret (FR)
(72) Erfinder: Jakob, Roland, Dr.-Ing., 12524 Berlin (DE); Nahrstaedt, Manfred, Dr., 12247 Berlin (DE)
(74) Vertreter: Dreiss, Fuhlendorf, Steimle & Becker

(57) **Zusammenfassung**

Die Erfindung betrifft eine Kühlvorrichtung (10), insbesondere für ein elektrisches Leistungshalbleiterbauelement. Die Kühlvorrichtung (10) ist mit einem Kühlkörper (11) versehen, der mit einem wärmeabgebenden Bauteil gekoppelt ist. Weiterhin ist die Kühlvorrichtung (10) mit mindestens einem Wärmerohr (12) versehen, das mit dem Kühlkörper (11) gekoppelt ist. Ein Wärmetauscher (14) ist vorgesehen, dem eine Kühlflüssigkeit zuführbar ist. Das Wärmerohr (12) ist derart mit dem Wärmetauscher (14) gekoppelt, dass Wärme von dem Wärmerohr (12) direkt oder indirekt an die Kühlflüssigkeit abgebbar ist.

## Beschreibung

Die Erfindung geht aus von einer Kühlvorrichtung, insbesondere für ein elektrisches Leistungshalbleiterbauelement, mit einem Kühlkörper, der mit einem wärmeabgebenden Bauteil gekoppelt ist, sowie mit mindestens einem Wärmerohr, das mit dem Kühlkörper gekoppelt ist.

Beispielsweise zur Kühlung von Bauteilen eines Personalcomputers ist es bekannt, sogenannte Wärmerohre (englisch: heat pipe) einzusetzen.

Bei einem derartigen Wärmerohr befindet sich eine Flüssigkeit in einem evakuierten, hermetisch abgeschlossenen Metallrohr. Wenn das Wärmerohr an seinem heißen Ende mit einem wärmeerzeugenden Bauteil des Personalcomputers in Kontakt kommt, verdampft die Flüssigkeit und transportiert die Wärmeenergie zum kalten Ende des Rohrs. Dort kondensiert die Flüssigkeit und gibt die Wärmeenergie an das Rohr und dessen Umgebung ab. Die kondensierte Flüssigkeit fließt danach beispielsweise mit Hilfe der Gravitationskraft oder mittels einer Kapillarwirkung wieder zurück zu dem heißen Ende des Wärmerohrs.

Weiterhin ist bekannt, das kalte Ende des Wärmerohrs mit einem Luftkühler zu koppeln, um auf diese Weise die abgegebene Wärmeenergie über den Luftkühler möglichst effektiv an die Umgebungsluft abzuführen.

Für den Einsatz eines derartigen Wärmerohrs beispielsweise zur Kühlung eines Thyristors ist es bekannt, das Rohr zumindest teilweise aus einem isolierenden Material, z.B. aus Keramik herzustellen.

Beispielsweise bei elektrischen Stromrichtern im Mittelspannungsbereich werden die Leistungshalbleiterbauelemente mit Kühlkörpern versehen, die zur Erreichung der erforderlichen Kühlwirkung mit Wasser gekühlt werden. Das Wasser zirkuliert in einem Kühlkreislauf und die vom Wasser aufgenommene Wärmeenergie wird beispielsweise über einen Luftkühler an die Umgebungsluft abgegeben.

Bei einem Stromrichter werden hohe Anforderungen an die Isolationsspannung gestellt. Unter anderem durch die Verwendung von deionisiertem Wasser wird insoweit erreicht, dass zwischen den über den Kühlkreislauf verbundenen Leistungshalbleiterbauelementen trotz unterschiedlicher elektrischer Potentiale kein wesentlicher Stromfluss entsteht. Da bereits ein relativ geringer Stromfluss zu schädigenden Elektrolysevorgängen führen kann, muss insbesondere der Zustand des Wassers laufend überwacht werden. Dies erfordert einen erheblichen Aufwand.

Aufgabe der Erfindung ist es, eine Kühlvorrichtung zu schaffen, die eine hohe Kühlwirkung besitzt, deren Betrieb aber trotzdem nur einen geringen Aufwand erfordert.

Bei einer Kühlvorrichtung der eingangs genannten Art wird diese Aufgabe erfindungsgemäß dadurch gelöst, dass ein Wärmetauscher vorgesehen ist, dem eine Kühlflüssigkeit zuführbar ist, und dass das Wärmerohr derart mit dem Wärmetauscher gekoppelt ist, dass Wärme von dem Wärmerohr direkt oder indirekt an die Kühlflüssigkeit abgebbar ist.

Die Erfindung stellt eine Flüssigkeitskühlung des Kühlkörpers zur Verfügung. Dies wird dadurch erreicht, dass die Wärme über das Wärmerohr von dem Kühlkörper abgeführt wird, und dass dann das Wärmerohr direkt oder indirekt von der Kühlflüssigkeit gekühlt wird.

Der wesentliche Vorteil dieser Vorgehensweise besteht darin, dass durch das flüssigkeitsgekühlte Wärmerohr wesentlich mehr Wärme von dem Kühlkörper abgeführt werden kann als bisher. Die erfindungsgemäße Kühlvorrichtung weist somit eine wesentlich höhere Kühlwirkung auf als bekannte derartige Kühlvorrichtungen.

Gleichzeitig ist für den Betrieb der erfindungsgemäßen Kühlvorrichtung kein erhöhter Aufwand erforderlich. Statt dessen kann die Flüssigkeitskühlung des Wärmerohrs auf eine einfache Art und Weise realisiert und betrieben werden kann.

Bei einer vorteilhaften Ausgestaltung der erfindungsgemäßen Kühlvorrichtung weist der Wärmetauscher einen Hohlraum sowie einen Zulauf und einen Ablauf auf, wobei die Kühlflüssigkeit über den Zulauf und den Ablauf dem Hohlraum zuführbar ist. Diese Ausgestaltung erfordert nur einen geringen Aufwand für die Realisierung und den Betrieb des Wärmetauschers.

Besonders vorteilhaft ist es, wenn sich das Wärmerohr in den Hohlraum erstreckt. In diesem Fall findet somit ein direkter Übergang von Wärmeenergie von dem Wärmerohr an die Kühlflüssigkeit statt. Auf diese Weise wird ohne größeren Aufwand ein erhöhter Wärmeübergang von dem Wärmerohr in die Kühlflüssigkeit erreicht.

Bei einer anderen vorteilhaften Ausgestaltung der Erfindung weist der Wärmetauscher eine Bohrung oder dergleichen sowie einen Zulauf und einen Ablauf auf, wobei die Kühlflüssigkeit über den Zulauf und den Ablauf der Bohrung zuführbar ist. Besonders vorteilhaft ist es dabei, wenn sich das Wärmerohr in den Wärmetauscher erstreckt. In diesem Fall findet ein indirekter Übergang der Wärmeenergie von dem Wärmerohr über das Material des Wärmetauschers an die Kühlflüssigkeit statt.

Bei einer vorteilhaften Weiterbildung der erfindungsgemäßen Kühlvorrichtung ist das Wärmerohr mit mindestens einem Isolationskörper versehen. Damit wird auf einfache Weise erreicht, dass der Kühlkörper und der Wärmetauscher elektrisch voneinander getrennt sind. Befinden sich auf dem Kühlkörper elektrische Bauteile, beispielsweise elektrische Bauteile eines Stromrichters oder dergleichen, so bedeutet dies, dass auch diese elektrischen Bauteile aufgrund des Isolationskörpers von dem Wärmetauscher elektrisch getrennt sind. Besondere Vorkehrungen für eine derartige elektrische Isolation sind damit nicht erforderlich.

Besonders vorteilhaft ist es, wenn als Kühlflüssigkeit unbehandeltes Wasser vorgesehen ist. Der Aufwand, der beispielsweise mit der Verwendung von deionisiertem Wasser verbunden ist, ist somit erfindungsgemäß nicht erforderlich. Ebenfalls ist keine Überwachung der Kühlflüssigkeit hinsichtlich ihrer Eigenschaften notwendig. Dies vereinfacht den Betrieb der erfindungsgemäßen Kühlvorrichtung wesentlich und vermindert ersichtlich den für den Betrieb erforderlichen Aufwand.

Besonders vorteilhaft ist es, wenn die erfindungsgemäße Kühlvorrichtung bei einem elektrischen Stromrichter insbesondere im Mittelspannungsbereich verwendet wird.

In diesem Fall wird einerseits durch den Einsatz des Wärmerohrs eine optimale Abführung der von dem zugehörigen Leistungshalbleiterbauelement erzeugten Wärme erreicht. Andererseits wird durch die Flüssigkeitskühlung des Wärmerohrs eine optimale Abführung der Wärme von dem Wärmerohr in die Kühlflüssigkeit erreicht. Der Aufwand für die Realisierung der gesamten Kühlvorrichtung ist dabei gering. Insbesondere kann durch einen entsprechenden Isolationskörper innerhalb des Wärmerohrs auf einfache Weise eine elektrische Trennung des Leistungshalbleiterbauelements von dem Wärmetauscher und damit auch von der Kühlflüssigkeit erreicht werden. Damit ist es weiterhin in vorteilhafter Weise möglich, dass als Kühlflüssigkeit unbehandeltes Wasser verwendet wird, das auch im Betrieb der Kühlvorrichtung keine weitere Überwachung erfordert.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

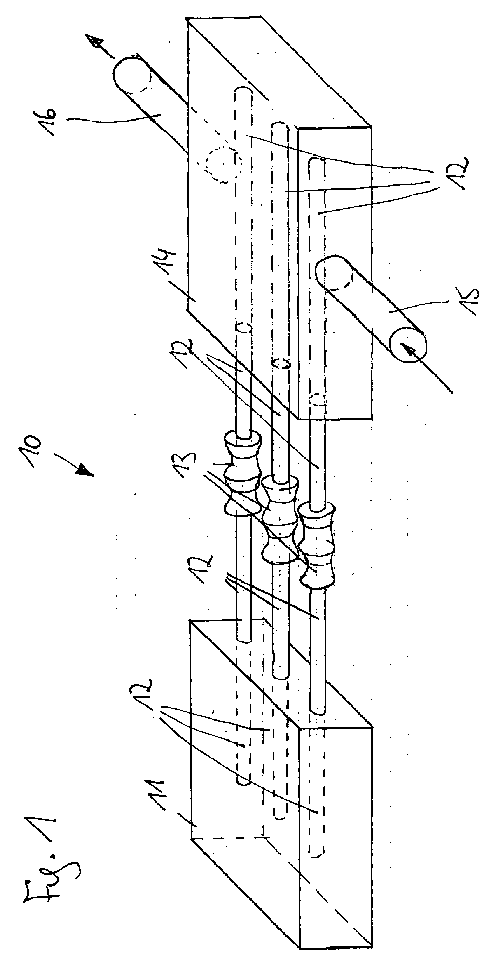

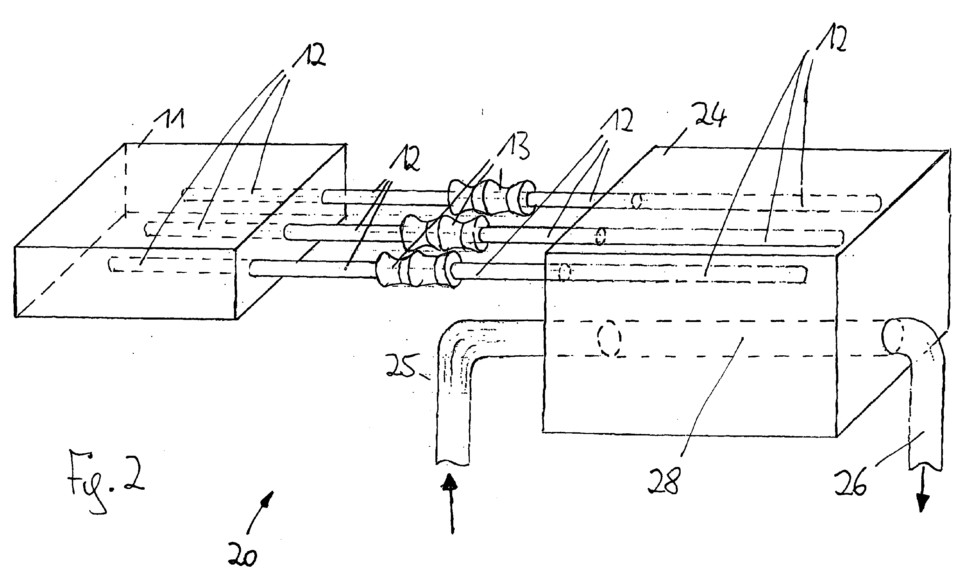

Figur 1 der zeichnung zeigt eine schematische Blockdarstellung eines ersten Ausführungsbeispiels einer erfindungsgemäßen Kühlvorrichtung, insbesondere für ein elektrisches Leistungshalbleiterbauelement, und Figur 2 zeigt eine schematische Blockdarstellung eines zweiten Ausführungsbeispiels einer erfindungsgemäßen Kühlvorrichtung.

In der Figur 1 ist eine Kühlvorrichtung 10 dargestellt, die grundsätzlich im Zusammenhang mit jeglichen technischen Anwendungen eingesetzt werden kann.

Die Kühlvorrichtung 10 weist einen Kühlkörper 11 auf, der in der Figur 1 quaderförmig dargestellt ist. Es versteht sich, dass der Kühlkörper 11 auch jegliche andere Gestalt aufweisen kann.

In nicht-dargestellter Weise ist auf oder an dem Kühlkörper 11 ein wärmeerzeugendes oder wärmeabgebendes Bauteil derart angeordnet, dass ein Wärmeübergang von dem Bauteil auf den Kühlkörper 11 erfolgt. Bei diesem Bauteil kann es sich um jegliches technische Bauteil handeln, das im Betrieb Wärme erzeugt oder abgibt. Das Bauteil kann unmittelbar mit dem Kühlkörper 11 verbunden sein oder über wärmeleitende Materialien an dem Kühlkörper 11 angebracht sein. Das Bauteil kann eine beliebige Form aufweisen, wobei der Kühlkörper 11 vorzugsweise an die Form des Bauteils angepasst ist. Weiterhin ist es möglich, dass das wärmeerzeugende Bauteil und der Kühlkörper 11 einstückig ausgebildet sind, also dass der Kühlkörper 11 in das Bauteil integriert ist oder umgekehrt.

Gemäß der Figur 1 ist der Kühlkörper 11 mit den Endbereichen dreier Wärmerohre 12 wärmeleitend gekoppelt. Es versteht sich, dass auch nur ein einzelnes Wärmerohr 12 oder eine sonstige Anzahl von Wärmerohren 12 vorgesehen sein kann. Die Wärmerohre 12 sind im vorliegenden Ausführungsbeispiel etwa gleich lang. Nachfolgend wird eines dieser Wärmerohre 12 beschrieben.

Bei dem Wärmerohr 12 handelt es sich um ein bekanntes Wärmerohr, wie es eingangs beschrieben wurde, und wie es auch unter der Bezeichnung "heat pipe" bekannt ist.

Die Kopplung des Wärmerohrs 12 mit dem Kühlkörper 11 kann dadurch erfolgen, dass der Endbereich des Wärmerohrs 12 sich bis in den Kühlkörper 11 hinein erstreckt bzw. in den Kühlkörper 11 eingelassen ist. Beispielsweise kann der Kühlkörper 11 eine Bohrung aufweisen, in die der Endbereich des Wärmerohrs 12 eingesteckt ist. Ebenfalls ist es möglich, dass die Stirnfläche des freien Endes des Wärmerohrs 12 oder die Mantelfläche des Endbereichs des Wärmerohrs 12 an einer Außenfläche des Kühlkörpers 11 anliegt. Wärme kann somit von dem Kühlkörper 11 an das Wärmerohr 12 abgegeben werden.

Bei dem mit dem Kühlkörper 11 gekoppelten Endbereich des Wärmerohrs 12 handelt es sich um das sogenannte heiße Ende desselben.

Das Wärmerohr 12 weist einen Isolationskörper 13 auf, der beispielsweise aus Keramik besteht. In der Figur 1 ist der Isolationskörper 13 etwa in der Mitte der Längsausdehnung des Wärmerohrs 12 angeordnet. Es ist aber auch möglich, dass der Isolationskörper 13 nicht in der Mitte der Längsausdehnung des Wärmerohrs 12 angeordnet ist, sondern im Bereich eines seiner freien Enden. So ist es auch möglich, dass der Isolationskörper 13 unmittelbar an den Kühlkörper 11 angrenzt oder sogar zumindest teilweise in diesem aufgenommen ist.

Weiterhin ist es möglich, dass mehrere Isolationskörper 13 im Verlauf des Wärmerohrs 12 vorhanden sind, oder dass das gesamte Wärmerohr 12 aus einem isolierenden Material, beispielsweise aus einem keramischen Material besteht. Im letztgenannten Fall sind die in der Figur 1 dargestellten Isolationskörper 13 nicht vorhanden.

Gemäß der Figur 1 sind die den heißen Enden gegenüberliegenden Endbereiche der Wärmerohre 12 mit einem Wärmetauscher 14 wärmeleitend gekoppelt. Bei diesen Endbereichen handelt es sich um die sogenannten kalten Enden der Wärmerohre 12.

Der Wärmetauscher 14 ist in der Figur 1 quaderförmig dargestellt. Es versteht sich, dass der Wärmetauscher 14 auch jegliche andere Gestalt aufweisen kann.

Der Wärmetauscher 14 weist einen in der Figur 1 nichtdargestellten Hohlraum auf, der mit einem Zulauf 15 und einem Ablauf 16 verbunden ist. Über den Zulauf 15 und den Ablauf 16 wird dem Hohlraum des Wärmetauschers 14 eine Kühlflüssigkeit zugeführt. Bei der Kühlflüssigkeit kann es sich beispielsweise um unbehandeltes Wasser handeln.

Die Endbereiche der kalten Enden der Wärmerohre 12 erstrecken sich in den Hohlraum des Wärmetauschers 14. Zu diesem Zweck sind in dem Wärmetauscher 14 Öffnungen enthalten, durch die die Wärmerohre 12 dicht in den Hohlraum eingeführt sind. Innerhalb des Hohlraums können Halterungen oder dergleichen zur Fixierung der Endbereiche der Wärmerohre 12 vorgesehen sein. Innerhalb des Hohlraums des Wärmetauschers 14 sind die Endbereiche der Wärmerohre 12 von der Kühlflüssigkeit umgeben. Wärme kann somit von den Wärmerohren 12 an die Kühlflüssigkeit abgegeben werden.

Der Zulauf 15 und der Ablauf 16 des Wärmetauschers 14 sind mit einem Kühlkreislauf verbunden, in dem die Kühlflüssigkeit zirkuliert. Innerhalb dieses Kühlkreislaufs ist zum Beispiel ein Luftkühler vorhanden, über den Wärme an die Umgebungsluft abgegeben werden kann.

Im Betrieb der beschriebenen Kühlvorrichtung 10 wird der Kühlkörper 11 von dem wärmeabgebenden Bauteil erwärmt. Über die Kopplung des Kühlkörpers 11 und der Wärmerohre 12 werden die heißen Enden dieser Wärmerohre 12 ebenfalls erwärmt. Dies führt dazu, dass die in den Wärmerohren 12 befindliche Flüssigkeit verdampft. Zusammen mit der verdampfenden Flüssigkeit wird Wärmeenergie von den heißen Enden zu den kalten Enden der Wärmerohre 12 transportiert. An den kalten Enden kondensiert die Flüssigkeit und gibt dabei die Wärmeenergie wieder ab. Aufgrund der Kopplung der Wärmerohre 12 und des Wärmetauschers 14 geht die Wärmeenergie in die in dem Hohlraum des Wärmetauschers 14 vorhandene Kühlflüssigkeit über. Zusammen mit dem zirkulierenden Kühlkreislauf wird die Wärmeenergie aus dem Wärmetauscher 14 abgeführt. Über den beispielhaft genannten Luftkühler wird die Wärmeenergie schließlich an die Umgebungsluft abgegeben. Die an den kalten Enden der Wärmerohre 12 kondensierte Flüssigkeit fließt aufgrund der Gravitationskraft oder aufgrund einer Kapillarwirkung innerhalb der Wärmerohre 12 von den kalten Enden zurück zu den heißen Enden. Dort kann die Flüssigkeit wieder von dem wärmeerzeugenden Bauteil über den Kühlkörper 11 erwärmt und verdampft werden, so dass der beschriebene Ablauf von vorne beginnt.

Die beschriebene Kühlvorrichtung 10 kann vorzugsweise bei einem elektrischen Stromrichter im Mittelspannungsbereich eingesetzt werden, der eine Mehrzahl von Leistungshalbleiterbauelementen aufweist.

In diesem Fall ist es möglich, dass jedes der Leistungshalbleiterbauelemente unter Zwischenfügung eines wärmeleitenden Materials, beispielsweise einer Wärmeleitpaste, auf einem einzelnen Kühlkörper 11 befestigt ist. Ebenfalls ist es möglich, dass eine Mehrzahl von Leistungshalbleiterbauelementen in entsprechender Weise auf einem einzelnen Kühlkörper 11 angeordnet sind. Die von dem bzw. den Leistungshalbleiterbauelementen erzeugte bzw. abgegebene Wärme wird damit an den bzw. die Kühlkörper 11 weitergegeben.

Von dem bzw. den Kühlkörpern 11 gelangt die Wärme über das bzw. die Wärmerohre 12 zu dem Wärmetauscher 14. Es versteht sich, dass auch mehrere derartige Wärmetauscher 14 vorhanden sein können. Von diesem bzw. diesen Wärmetauschern 14 wird die Wärme an die Kühlflüssigkeit abgegeben und von dieser abtransportiert.

Durch den bzw. die Isolationskörper 13 sind der bzw. die Kühlkörper 11 einerseits und der bzw. die Wärmetauscher 14 andererseits elektrisch voneinander isoliert. Dies bedeutet, dass auch zwischen den auf den Kühlkörpern 11 angebrachten Leistungshalbleiterbauelementen keine elektrische Verbindung besteht. Durch eine entsprechende Materialauswahl und Formgestaltung kann der elektrische Widerstand des bzw. der Isolationskörper 13 an die jeweilige Anwendung, insbesondere an die erwünschte Isolationsspannung angepasst werden.

Damit ist es möglich, die an die Isolationsspannung gestellten hohen Anforderungen allein durch eine entsprechende Ausgestaltung der Isolationskörper 13 sowie der sonstigen Isolation zwischen den Kühlkörpern 11 und/oder den darauf vorhandenen Leistungshalbleiterbauelementen zu erreichen. Aufgrund der elektrischen Trennung spielen der bzw. die Wärmetauscher 14 und insbesondere die dort vorhandene Kühlflüssigkeit im Hinblick auf die Isolationsspannung jedoch keine Rolle.

Es ist damit nicht erforderlich, besondere Vorkehrungen im Hinblick auf die Kühlflüssigkeit zu treffen. Statt dessen kann beispielsweise unbehandeltes Wasser als Kühlflüssigkeit verwendet werden, das auch im Betrieb der Kühlvorrichtung keiner weiteren Überwachung bedarf.

In der Figur 2 ist eine Kühlvorrichtung 20 dargestellt, die in ihrem Aufbau und ihrer Funktionsweise weitgehend mit der Kühlvorrichtung 10 der Figur 1 übereinstimmt. Gleichartige Merkmale sind deshalb mit gleichen Bezugszeichen gekennzeichnet. Im Hinblick auf diese übereinstimmenden Merkmale der Kühlvorrichtung 20 der Figur 2 wird auf die Erläuterungen zu der Kühlvorrichtung 10 der Figur 1 verwiesen.

Nachfolgend sind nur diejenigen Merkmale der Kühlvorrichtung 20 der Figur 2 näher erläutert, die von der Kühlvorrichtung 10 der Figur 1 abweichen. Dabei handelt es sich im wesentlichen um den Wärmetauscher 14 der Figur 1, der in der Figur 2 in abweichender Weise realisiert ist.

Bei der Kühlvorrichtung 20 der Figur 2 sind die den heißen Enden gegenüberliegenden Endbereiche der Wärmerohre 12 mit einem Wärmetauscher 24 wärmeleitend gekoppelt. Bei diesen Endbereichen handelt es sich um die genannten kalten Enden der Wärmerohre 12.

Der Wärmetauscher 24 ist in der Figur 2 quaderförmig dargestellt. Es versteht sich, dass der Wärmetauscher 24 auch jegliche andere Gestalt aufweisen kann.

Der Wärmetauscher 24 weist keinen Hohlraum auf. Statt dessen erfolgt die Kopplung der Wärmerohre 12 mit dem Wärmetauscher 24 dadurch, dass die Endbereiche der Wärmerohre 12 sich bis in den Wärmetauscher 24 hinein erstrecken bzw. in den Wärmetauscher 24 eingelassen sind. Beispielsweise kann der Wärmetauscher 24 entsprechende Bohrungen aufweisen, in die die Endbereiche der Wärmerohre 12 eingesteckt sind. Ebenfalls ist es möglich, dass die Stirnfläche der freien Enden der Wärmerohre 12 oder die Mantelfläche der Endbereiche der Wärmerohre 12 an einer Außenfläche des Wärmetauschers 24 anliegt. Wärme kann somit von den Endbereichen der Wärmerohre 12 an den Wärmetauscher 24 abgegeben werden.

Der Wärmetauscher 24 weist eine Bohrung 28 auf, die mit einem Zulauf 25 und einem Ablauf 26 verbunden ist. Es versteht sich, dass es sich bei der Bohrung 28 auch um jegliche andere Art einer Öffnung in dem Wärmetauscher 24 handeln kann. Ebenfalls versteht es sich, dass mehrere derartige Bohrungen vorhanden sein können. Über den Zulauf 25 und den Ablauf 26 wird der Bohrung 28 des Wärmetauschers 24 eine Kühlflüssigkeit zugeführt. Bei der Kühlflüssigkeit kann es sich beispielsweise um unbehandeltes Wasser handeln.

Der Zulauf 25 und der Ablauf 26 des Wärmetauschers 24 sind mit einem Kühlkreislauf verbunden, in dem die Kühlflüssigkeit zirkuliert. Innerhalb dieses Kühlkreislaufs ist zum Beispiel ein Luftkühler vorhanden, über den Wärme an die Umgebungsluft abgegeben werden kann.

Im Betrieb der beschriebenen Kühlvorrichtung 20 der Figur 2 wird Wärmeenergie, wie dies bereits im Zusammenhang mit der Kühlvorrichtung 10 der Figur 1 erläutert wurde, von den heißen Enden zu den kalten Enden der Wärmerohre 12 transportiert. An den kalten Enden kondensiert die Flüssigkeit und gibt dabei die Wärmeenergie wieder ab. Aufgrund der Kopplung der Wärmerohre 12 und des Wärmetauschers 24 wird die Wärmeenergie von dem Material des Wärmetauschers 24 aufgenommen. Von diesem Material wird die Wärmeenergie an die in der Bohrung 28 des Wärmetauschers 24 vorhandene Kühlflüssigkeit abgegeben. Zusammen mit dem zirkulierenden Kühlkreislauf wird die Wärmeenergie aus dem Wärmetauscher 24 abgeführt. Über den beispielhaft genannten Luftkühler wird die Wärmeenergie schließlich an die Umgebungsluft abgegeben.

Der Unterschied zwischen der Kühlvorrichtung 10 der Figur 1 und der Kühlvorrichtung 20 der Figur 2 besteht somit im wesentlichen darin, dass bei der Kühlvorrichtung 10 der Figur 1 die Wärmeenergie von den Endbereichen der Wärmerohre 12 direkt in die Kühlflüssigkeit, die den Wärmetauscher 14 durchströmt, übergeht, während bei der Kühlvorrichtung 20 der Figur 2 die Wärmeenergie von den Endbereichen der Wärmerohre 12 indirekt in die den Wärmetauscher 24 durchströmende Kühlflüssigkeit übergeht, und zwar über das Material des Wärmetauschers 24.

## Patentansprüche

1. Kühlvorrichtung (10, 20), insbesondere für ein elektrisches Leistungshalbleiterbauelement, mit einem Kühlkörper (11), der mit einem wärmeabgebenden Bauteil gekoppelt ist, sowie mit mindestens einem Wärmerohr (12), das mit dem Kühlkörper (11) gekoppelt ist, **dadurch gekennzeichnet, dass** ein Wärmetauscher (14, 24) vorgesehen ist, dem eine Kühlflüssigkeit zuführbar ist, und dass das Wärmerohr (12) derart mit dem Wärmetauscher (14, 24) gekoppelt ist, dass Wärme von dem Wärmerohr (12) direkt oder indirekt an die Kühlflüssigkeit abgebbar ist.

2. Kühlvorrichtung (10) nach Anspruch 1, **dadurch gekennzeichnet, dass** der Wärmetauscher (14) einen Hohlraum sowie einen Zulauf (15) und einen Ablauf (16) aufweist, und dass die Kühlflüssigkeit über den Zulauf (15) und den Ablauf (16) dem Hohlraum zuführbar ist.

3. Kühlvorrichtung (10) nach Anspruch 2, **dadurch gekennzeichnet, dass** sich das Wärmerohr (12) in den Hohlraum erstreckt.

4. Kühlvorrichtung (10) nach Anspruch 3, **dadurch gekennzeichnet, dass** der Wärmetauscher (14) eine Öffnung aufweist, durch die das Wärmerohr (12) dicht in den Hohlraum eingeführt ist.

5. Kühlvorrichtung (20) nach Anspruch 1, **dadurch gekennzeichnet, dass** der Wärmetauscher (24) eine Bohrung (28) oder dergleichen sowie einen Zulauf (25) und einen Ablauf (26) aufweist, und dass die Kühlflüssigkeit über den Zulauf (25) und den Ablauf (26) der Bohrung (28) zuführbar ist.

6. Kühlvorrichtung (20) nach Anspruch 5, **dadurch gekennzeichnet, dass** sich das Wärmerohr (12) in den Wärmetauscher (24) erstreckt.

7. Kühlvorrichtung (20) nach Anspruch 6, **dadurch gekennzeichnet, dass** der Wärmetauscher (24) eine Bohrung aufweist, in die das Wärmerohr (12) eingesteckt ist.

8. Kühlvorrichtung (10, 20) nach einem der vorstehenden Ansprüche, **dadurch gekennzeichnet, dass** Mittel zur Zirkulation der Kühlflüssigkeit in einem Kühlkreislauf vorgesehen sind.

9. Kühlvorrichtung (10, 20) nach einem der vorstehenden Ansprüche, **dadurch gekennzeichnet, dass** das Wärmerohr (12) mit mindestens einem Isolationskörper (13) versehen ist.

10. Kühlvorrichtung (10, 20) nach einem der vorstehenden Ansprüche, **dadurch gekennzeichnet, dass** als Kühlflüssigkeit unbehandeltes Wasser vorgesehen ist.

11. Kühlvorrichtung (10, 20) nach einem der vorstehenden Ansprüche, **gekennzeichnet durch** die Verwendung der Kühlvorrichtung (10, 20) bei einem elektrischen Stromrichter insbesondere im Mittelspannungsbereich.

12. Kühlvorrichtung (10, 20) nach Anspruch 11, **dadurch gekennzeichnet, dass** das Leistungshalbleiterbauelement über ein wärmeleitendes Material mit dem Kühlkörper (11) verbunden ist.
